# EUROPEAN PATENT APPLICATION

(11) **EP 4 815 382 A2**
(43) Date of publication of application: **30.09.2026**
(21) Application number: 26168117.5
(22) Date of filing: 26.03.2026
(51) Int. Cl.: H04L 25/49, H04L 25/03

(54) **MULTI-PROTOCOL INPUT/OUTPUT (I/O) COMMUNICATION**

(30) Priority: 28.03.2025 US 202519093962
(71) Applicant: Altera Corporation, San Jose, CA 95134 (US)
(72) Inventor: GOH, Seh Leong, 11900 SUNGAI ARA (MY); BONG, Pai Ho, 11900 BAYAN LEPAS (MY); NAVARATNAM, Navindra, Portland, 97229 (US)
(74) Representative: 2SPL Patentanwälte PartG mbB

(57) **Abstract**

Systems or methods of the present disclosure may provide transmit circuitry that receives one or more input signals and an enable signal, the enable signal indicating whether a three-level communication scheme is enabled, and generates one or more data signals based on the one or more input signals and the enable signal. Equalization circuitry receives the one or more data signals and selectively generates a first set of equalization voltages based on the one or more data signals indicating the three-level communication scheme or selectively generates a second set of equalization voltages based on the one or more data signals not indicating the three-level communication scheme.

## Description

### BACKGROUND

This disclosure relates to systems and methods for programmable multi-protocol (e.g., multistandard) signaling communication between electronic devices.

This section is intended to introduce the reader to various aspects of art that may be related to various aspects of the present disclosure, which are described and/or claimed below. This discussion is believed to be helpful in providing the reader with background information to facilitate a better understanding of the various aspects of the present disclosure. Accordingly, it may be understood that these statements are to be read in this light, and not as admissions of prior art.

Integrated circuits are found in numerous electronic devices and provide a variety of functionality. Communication between different integrated circuits has become increasingly sophisticated to increase the rate that data is transferred from one electronic device to another electronic device. In some communication schemes, such as non-return-to-zero (NRZ), a transmitter circuit of a first electronic device sends a signal to a receiver circuit of a second electronic device that has symbols that can be one of two different voltage signal levels. One of the signal levels is interpreted by the receiver circuit as a "1" while the other signal level is interpreted as a "0." To communicate even more data per symbol, some communication schemes apply multi-level signaling. Multi-level signaling communication schemes use symbols that can be one of several different signal levels, such as three different signals levels. These three different voltage levels may be interpreted by the receiver circuit as "00," "10," or "11."

Further, multi-protocol integrated circuits may be designed to use various multiple communication schemes, each having different numbers of voltage levels used for communication. For example, multi-protocol transmitter circuitry of an integrated circuit may support one or more NRZ communication schemes (e.g., push-pull driver, high voltage I/O, LVSTL, SLVS) and/or multi-level signaling schemes, such as MIPI level camera physical layer (CPHY)). However, including more complex and/or numerous circuit topologies to support the multiple schemes may lead to challenges. Including additional driver branches, for example, may introduce problematic levels of parasitic capacitance, especially at high data transmission rates.

### BRIEF DESCRIPTION OF THE DRAWINGS

Various aspects of this disclosure may be better understood upon reading the following detailed description and upon reference to the drawings in which:
FIG. 1 is a block diagram of a system to enable communication between two integrated circuit devices with multi-protocol Input/Output (I/O) Communication;
FIG. 2 is a schematic diagram of transmit circuitry that serializes input signals and generates voltages according to various communication schemes;
FIG. 3 is a schematic diagram of driver circuitry that transmits or receives signals based on the voltages generated by the transmit circuitry of FIG. 2;
FIG. 4 is a schematic diagram of equalization circuitry that receives serialized input signals and generates equalization voltages according to various communication schemes;
FIGS. 5-13 are schematic diagrams of driver circuitry operating according to different scenarios of a three-level communication scheme to generate different equalization signals;
FIG. 14 is a flow chart of a method for selectively generating voltage levels based on various communication schemes;
FIG. 15 is a flow chart of a method for selectively generating equalization voltages based on various communication schemes; and
FIG. 16 is a block diagram of a data processing system that may incorporate the systems and methods of this disclosure.

### DETAILED DESCRIPTION OF SPECIFIC EMBODIMENTS

One or more specific embodiments will be described below. In an effort to provide a concise description of these embodiments, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features. Furthermore, the phrase A "based on" B is intended to mean that A is at least partially based on B. Moreover, the term "or" is intended to be inclusive (e.g., logical OR) and not exclusive (e.g., logical XOR). In other words, the phrase A "or" B is intended to mean A, B, or both A and B.

In addition to increasing data transfer rates between electronic devices, integrated circuits increasingly use various communication schemes to transfer data, such as one-level, two-level, or three-level schemes, each using different numbers of voltage signal levels to transfer data. It may be desirable to support the multiple voltages of the multiple schemes without increasing the number of drivers or wires (e.g., driver branches, driver outputs) of the transmitter circuitry. The present systems and techniques relate to embodiments for programmable multi-scheme I/O circuitry that selectively generates voltage signal levels according to one of various schemes. The systems and techniques of this disclosure use common output wires for one-level, two-level, and three-level schemes (e.g., multi-level communication schemes), mitigating impact to existing circuitry (e.g., receiver circuitry) that use the output wires. Additionally, the disclosed I/O circuitry selectively generates equalization signals for each of the one-level, two-level, and three-level schemes with minimal insertion delay impact.

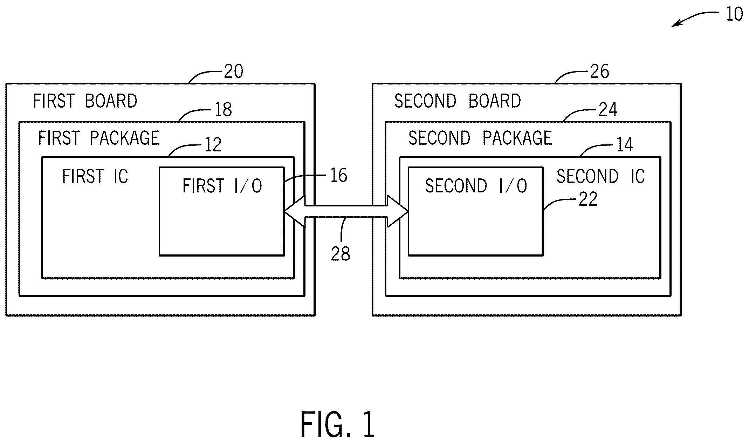

FIG. 1 illustrates a communication system 10 to enable communication between a first integrated circuit (IC) 12 and a second IC 14. The first IC 12 and the second IC 14 may be any suitable integrated circuits that may be in communication. For example, the first IC 12 and the second IC 14 may include programmable logic devices (PLDs), such as field programmable gate arrays (FPGAs), application specific integrated circuits (ASICs), processors (e.g., central processing units (CPUs), graphics processing units (GPUs)), artificial intelligence (AI) compute circuitry, memory or storage (e.g., random access memory (RAM), read only memory (ROM), nonvolatile memory, high-bandwidth memory (HBM)), or the like.

The first IC 12 may communicate using a first I/O 16. In the example of FIG. 1, the first IC 12 and the first I/O 16 are separate dies in a first package 18 on a first printed circuit board 20. In other examples, the first IC 12 and the first I/O 16 may be part of a single monolithic integrated circuit. The first I/O 16 may send communication to or receive communication from a second I/O 22 in communication with the second IC 14. In the example of FIG. 1, these are also shown as separate dies in a second package 24 on a second printed circuit board 26. In other examples, the second IC 14 and the second I/O 22 may be part of a single monolithic integrated circuit. A communication link 28 may include transmission lines from the first I/O 16 to the second I/O 22 and/or transmission lines from the second I/O 22 to the first I/O 16. The first IC 12 may communicate with the second IC 14 using any suitable signaling protocol. While this disclosure will use examples with one-level, two-level, and three-level camera physical layer (CPHY) signals, other multi-level signaling schemes may be used with any suitable number of signal levels.

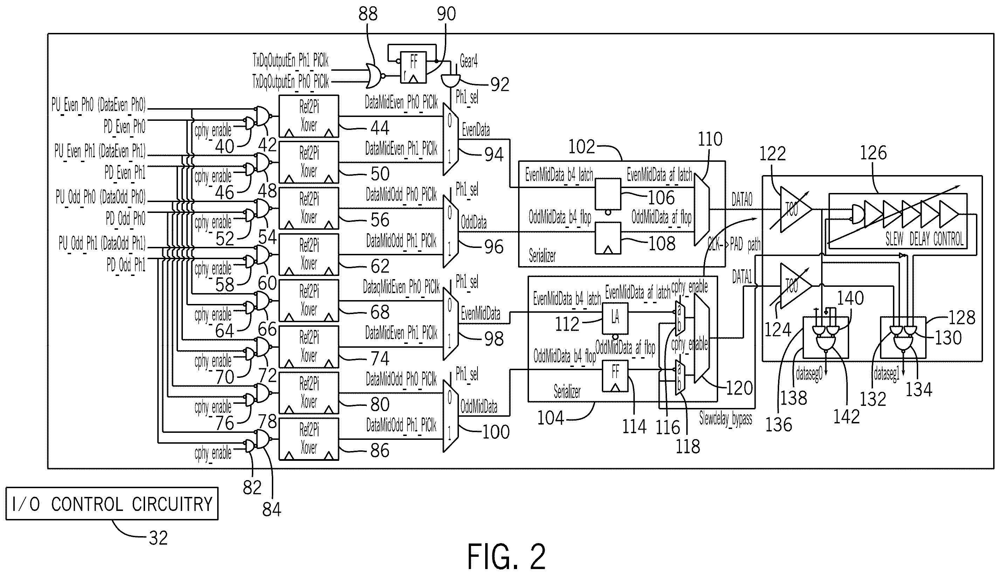

FIG. 2 is a schematic diagram of transmit circuitry 30 that selectively generates voltage levels (e.g., output voltages, control voltages) for multiple communication schemes that may each use different voltage level combinations. In the illustrated example, the transmit circuitry 30 may selectively generate voltage levels for one-level (e.g., single-ended), two-level (e.g., differential), or three-level schemes based on signals from I/O control circuitry 32. The transmit circuitry 30 may include or be included as part of, for example, the first IC 12 or the second IC 14 of FIG. 1, and the I/O control circuitry 32 may include or be included as part of the first I/O 16 or the second I/O 22. The I/O control circuitry 32 may include programmable logic devices (PLDs), such as field programmable gate arrays (FPGAs), application specific integrated circuits (ASICs), processors (e.g., central processing units (CPUs), graphics processing units (GPUs)), artificial intelligence (AI) compute circuitry, memory or storage (e.g., random access memory (RAM), read only memory (ROM), nonvolatile memory, high-bandwidth memory (HBM)), or the like.

The transmit circuitry 30 may generate two output signals, here illustrated as a dataseg0 signal and a dataseg1 signal, based on data signals (e.g., input data signals) generated by the I/O control circuitry 32, which may include even and odd portions (e.g., even data signals and odd data signals) of pull-up signals and pull-down signals. For example, the transmit circuitry 20 may generate the two output signals as part of an FPGA configuration that includes the I/O control circuitry 32. In the illustrated example, the pull-up signals include PU_Even_Ph0 and PU_Even_Ph1 signals, which may be parallel versions of an even portion of the pull-up signal, and PU_Odd_Ph0 and PU_Odd_Ph1 signals, which may be parallel versions of an odd portion of the pull-up signal. The pull-down signals include PD_Even_Ph0 PD_Even_Ph1, PD_Odd_Ph0, and PD_Odd_Ph1 signals, which may include parallel versions of even and odd portions of the pull-down signal.

In addition, the I/O control circuitry 32 may generate enable signals that selectively enable certain communication schemes of the transmit circuitry. In the illustrated example, the I/O control circuitry 32 may generate a cphy_enable signal. Based on the cphy_enable signal, the transmit circuitry 30 may enable a three-level communication scheme to generate three voltage levels at the dataseg0 and dataseg1 outputs or disable the three-level communication scheme to generate fewer than three voltage levels at the dataseg0 and dataseg1 outputs. The transmit circuitry may serialize the data signals into an EvenData signal and an OddData signals (e.g., to yield serialized input data signals) when the three-level communication scheme is disabled and may serialize the data signals into the EvenData signal, the OddData signal, an EvenMidData signal, and an OddData signal when the three-level communication scheme is enabled.

To serialize the data signals, the data signals and the cphy_enable signals may be provided to NAND gates of the transmit circuitry 30. As illustrated, an inverted PD_Even_Ph0 and the cphy_enable may be provided to a NAND gate 40, and an output of the NAND gate 40 may be provided to a NAND gate 42 with an inverted PU_Even_Ph0. An output of the NAND gate 42 may be provided to a clock converter 44, which may convert the output of the NAND gate 42 from a first clock domain (e.g., of the data signals generated by the I/O control circuitry) to a second clock domain (e.g., of the dataseg0 and dataseg1 signals) to generate a first even data signal, illustrated as the DataEven_Ph0_piClk signal. The clock converter 44 may include registers, clock generation circuitry, and the like to generate the DataEven_Ph0_piClk signal.

Additionally, the cphy_enable and an inverted PD_Even_Ph1 may be provided to a NAND gate 46, and an output of the NAND gate 46 may be provided to a NAND gate 48 with an inverted PU_Even_Ph1. An output of the NAND gate 48 may be provided to a clock converter 50 to generate a second even data signal, illustrated as the DataEven_Ph1_PiClk signal. The cphy_enable and an inverted PD_Odd_Ph0 may be provided to a NAND gate 52, and an output of the NAND gate 52 may be provided to a NAND gate 54 with an inverted PU_Odd_Ph0. An output of the NAND gate 54 may be provided to a clock converter 56 to generate a first odd data signal, illustrated as the DataOdd_Ph0_PiClk signal. Further, the cphy_enable and an inverted PD_Odd_Ph1 may be provided to a NAND gate 58, and an output of the NAND gate 58 may be provided to a NAND gate 60 with an inverted PU_Odd_Ph1. An output of the NAND gate 60 may be provided to a clock converter 62 to generate a second odd data signal, illustrated here as the DataOdd_Ph1_PiClk signal.

Further, the cphy_enable and an inverted PD_Even_Ph0 may be provided to a NAND gate 64, and an output of the NAND gate 66 may be provided to a NAND gate 66 with the PU_Even_Ph0. An output of the NAND gate 66 may be provided to a clock converter 68 to generate a first even middle data signal, illustrated as the DataMidEven_Ph0_PiClk signal. The cphy_enable and the PD_Even_Ph1 may be provided to a NAND gate 70, and an output of the NAND gate 70 may be provided to a NAND gate 72 with the PU_Even_Ph1. An output of the NAND gate 72 may be provided to a clock converter 74 to generate a second mid even data signal, illustrated as the DataMidEven_Ph1_PiClk signal. The cphy_enable and an inverted PD_Odd_Ph0 may be provided to a NAND gate 76, and an output of the NAND gate 76 may be provided to a NAND gate 78 with the PU_Odd_Ph0. An output of the NAND gate 78 may be provided to a clock converter 80 to generate a first odd middle data signal, illustrated as the DataMidOdd_Ph0_PiClk signal. Further, the cphy_enable and an inverted PD_Odd_Ph1 may be provided to a NAND gate 82, and an output of the NAND gate 82 may be provided to a NAND gate 84 with the PU_Odd_Ph1. An output of the NAND gate 84 may be provided to a clock converter 86 to generate a second odd middle data signal, illustrated as the DataMidOdd_Ph1_PiClk signal.

The outputs of the clock converters may be multiplexed based on a Ph1_sel signal to form an even data signal, an odd data signal, an even middle data signal, and an odd middle data signal, here illustrated as EvenData, OddData, EvenMidData, and OddMidData signals. The EvenData, OddData, EvenMidData, and OddMidData signals may be serialized versions of each pair of inputs to respective multiplexers. In the illustrated example, the ph1_sel may be generated based on TxDqOutputEn_Ph0_PiClk TxDqOutputEn_Ph1_PiClk signals, which may be generated by the I/O control circuitry 32. The TxDqOutputEn_Ph0_PiClk TxDqOutputEn_Ph1_PiClk signals may be provided to a NOR gate 88, and an output of the NOR gate 88 may be provided to a flip flop 90 at a reset input r, and an output of the flip flop 90 may be provided with a Gear4 signal to an AND gate 92 to generate the Ph1_sel signal. The Gear4 signal, when asserted, may cause the multiplexers 94, 96, 98, and 100 to serialize the DataEven_Ph1_PiClk, DataOdd_Ph1_PiClk, DataMidEven_Ph1_PiClk, and DataMidEven_Ph1_PiClk signals.

As illustrated, a multiplexer (MUX) 94 may select between the DataEven_ph0_PiClk and DataEven_ph0_PiClk signals based on the Ph1_sel signal to generate the EvenData signal. Additionally, a multiplexer (MUX) 96 may select between the DataOdd_Ph0_PiClk and DataOdd_ph1_PiClk signals based on the Ph1_sel signal to generate the OddData signal. Further, a multiplexer (MUX) 98 may select between the DataMidEven_Ph0_PiClk and DataMidEven_ph1_PiClk signals based on the Ph1_sel signal to generate the EvenMidData signal. To generate the OddMidData signal, a MUX 100 may select between the DataMidOdd_Ph0_PiClk signal and the DataMidOdd_Ph1_PiClk signal based on the Ph1_sel signal. When the three-level communication scheme is disabled (e.g., when the cphy_enable signal is low), the EvenMidData and OddMidData may be unasserted. When the three-level communication scheme is enabled (e.g., when the cphy_enable signal is high), the EvenMidData and OddMidData may be asserted.

Serializers 102 and 104 of the transmit circuitry 30 may serialize the EvenData and OddData into a DATA0 signal (e.g., as a first stream of data) and may serialize the EvenMidData and OddMidData into a DATA1 signal (e.g., as a second stream of data). The EvenData may be provided to a latch 106 as an EvenData_b4_latch signal to generate EvenData_af_latch signal, (e.g., the even data signal as output from the latch 106) and the OddData may be provided to a flip flop 108 as an OddData_b4_flop signal to generate OddData_af_flop (e.g., the odd data signal as output from the flip flop 108). The EvenData_af_latch and OddData_af_flop are provided to a MUX 110 that generates the DATA0 signal. Further, the EvenMidData may be provided to a latch 112 as a EvenMidData_b4_latch signal to generate a EvenMidData_af_latch signal (e.g., the even middle data signal as output from the latch 112), and the OddMidData may be provided as an OddMidData_b4_flop signal to a flip flop 114 to generate OddMidData_af_flop (e.g., the odd middle data signal as output from the flip flop 114),. A MUX 116 may select, based on the cphy_enable signal, between the EvenMidData_af_latch and a slewdelay_bypass signal. Likewise, a MUX 118 may select, based on the cphy_enable signal, between the OddMidData_af_latch and a slewdelay_bypass signal. Outputs of the MUX 116 and the MUX 118 may be provided to a MUX 120 to generate the DATA1 signal.

The DATA0 and DATA1 signals may be provided to respective time clock outs (TCO) 122 and 124, which may be used to adjust rising and falling edges of the dataseg0 and dataseg1 signals. The TCO 122 may provide the DATA0 signal with an inverted slewdelay_bypass to a slew delay control block 126, which may create a delay difference between the dataseg0 and dataseg1 signal to control a slew rate of the dataseg0 and dataseg1 signals. For higher speeds, for example, the slewdelay_bypass may be asserted, which may lead to reduced slew delay.

An output of the slew delay control block 126, the inverted slewdelay_bypass, the DATA0 signal, and the DATA1 signal may be provided to dataseg1 control circuitry 128 to generate the dataseg1 signal. As illustrated, the output of the slew delay control block 126 and the inverted slewdelay_bypass may be provided to a NAND gate 130, and the DATA0 and DATA1 signals may be provided to a NAND gate 132. Outputs of the NAND gate 130 and the NAND gate 132 may be provided to a NAND gate 134, and the NAND gate 134 may generate the dataseg1.

The DATA0 signal may be provided to dataseg0 control circuitry 136 to generate the dataseg0 signal. As illustrated, the DATA0 signal may be provided to a NAND gate 138 with a ground input. Ground inputs may also be provided to a NAND gate 140, and outputs of the NAND gates 138 and 140 may be provided to a NAND gate 142 to generate the dataseg0 signal. The dataseg0 control circuitry 136 may be structured as such (e.g., with grounded NAND inputs) to be substantially the same as the structure of the dataseg1 control circuitry. As such, delays of the dataseg0 signals and dataseg1 signals may be substantially the same.

As mentioned, the transmit circuitry may generate the dataseg0 signal and the dataseg1 signals based on the pull-up signals and/or the pull-down signals. The table below shows example relationships between output voltage levels, pull-up signals, pull-down signals, dataseg0 signals, and dataseg1 signals:

**Table 1. Output Voltage Levels with dataseg0 and dataseg1 Signals**

| Output voltage level | PU | PD | dataseg0 | dataseg1 |
|---|---|---|---|---|
| High | 1 | 0 | 1 | 1 |
| Mid | 0 | 0 | 1 | 0 |
| Low | 0 | 1 | 0 | 0 |

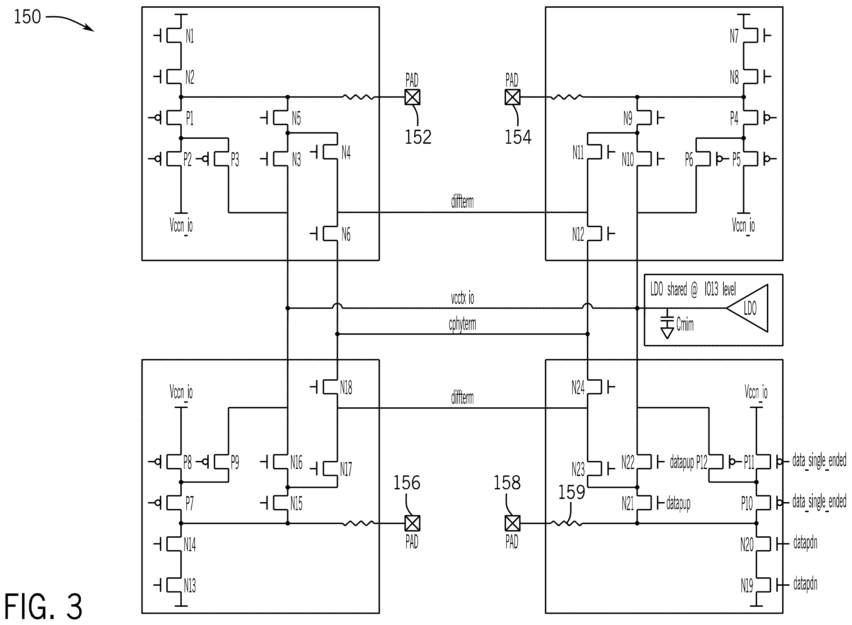

FIG. 3 is schematic diagram of driver circuitry 150 that generates voltages at driver pads 152, 154, 156, and 158. The driver circuitry 150 includes p-channel metal oxide semiconductor (PMOS) transistors P1-P12 and n-channel metal oxide semiconductor (NMOS) transistors N1-N24. The PMOS transistors P1-P12 and the NMOS transistors N1-N24 may be selectively gated to connect the pads 152, 154, 156, and 158 to a first supply voltage, illustrated as the Vcctx_io voltage, and a second supply voltage, illustrated as Vccn_io voltage.

For example, when in a CPHY transmit mode, a pull-up signal, illustrated as the datapup signal and a pull-down signal, illustrated as the datapdn signal, may each be asserted. This may turn P10 and P11 off, which may disconnect the pad 158 from the Vccn_io signal, and turn the N19, N20, N21 and N22 on, which may connect the pad 158 to the Vcctx_io signal through the resistor 159. When operating in a single-ended transmit mode, the datapup signal may not be asserted, which may turn the N21 and N22 off, and a datapup_single_ended signal may be asserted, turning the P10 and P11 on and connecting the pad 158 to the Vccn_io signal. The other pads 152, 154, and 156 may be driven similarly in the transmit mode.

When operating in a receive mode of a two-level scheme, two pads (e.g., the pads 156 and 158) may be used. For example, the N24 and N18 may be turned off, and the N21 and N23 may be turned on. As such, the diffterm node may include a two-level voltage between the pads 156 and 158. When operating in a CHPY receive mode, the pads 152, 156, and 158 may be used, and the pad 154 may be unused. To do so, the N5, N4, N6, N18, N17, N15, N24, N23, and N21 may be turned on, and the pads 152, 156, and 158 may be shunted together. However, the N12, N11, and/or N9 may be turned off, disconnecting the pad 154. As such, the cphyterm node may have a three-level voltage between the pads 152, 156, and 158.

Implementing three-level schemes along with two-level schemes may involve other considerations, including equalization. In a one-level or two-level scheme, one equalization signal may satisfy the one or two signal changing conditions for each signal state (e.g., low to low, low to high). In a three-level scheme, however, two equalization signals may be used to satisfy three scenarios for each signal state (e.g., low to low, low to medium, low to high).

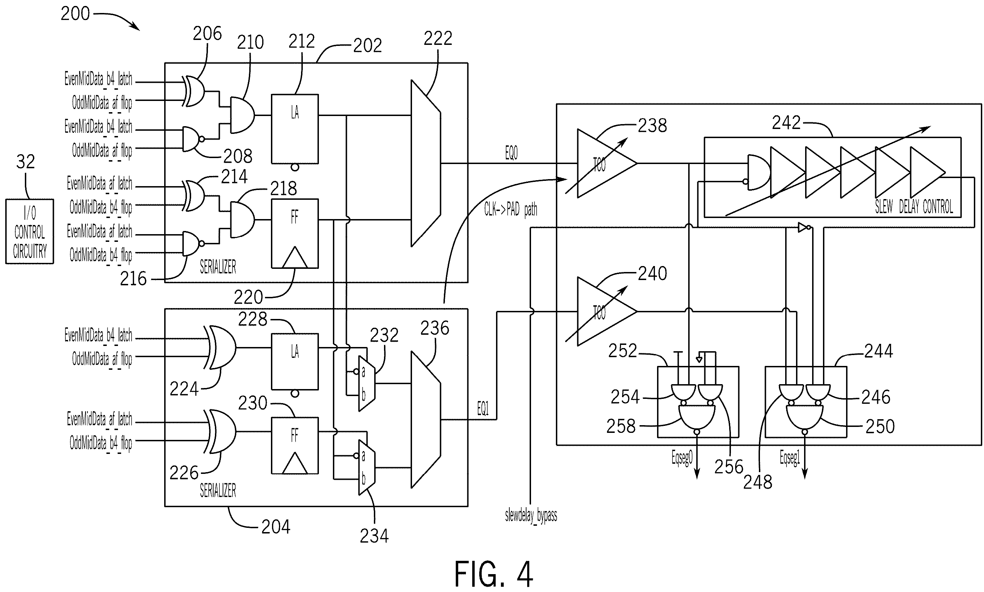

FIG. 4 is a schematic diagram of equalization circuitry 200 that selectively generates equalization voltages as Eqseg0 and Eqseg1 signals (e.g., equalization control voltages) according to multiple communication schemes. In the illustrated example, the transmit circuitry 30 may selectively generate equalization voltage levels for one-level (e.g., single-ended), two-level (e.g., differential), or three-level schemes based on signals from I/O control circuitry 32 and/or signals generated by the transmit circuitry 30 of FIG. 2. In a three-level scheme, for example, the equalization circuitry 200 may selectively generate three equalization signals for each of three different states of the dataseg0 and dataseg1 signals (e.g., for a total of nine input combinations). The equalization circuitry 200 may include or be included as part of, for example, the first IC 12 or the second IC 14 of FIG. 1.

The equalization circuitry 200 may include serializers 202 and 204 (e.g., serializer circuitry) that serialize received signals to generate EQ0 and EQ1 signals. The two serializers 202 and 204 may allow the generation of various equalization signals for nine scenarios of a three-level scheme. As illustrated, the EvenData_b4_latch signal and the OddData_af_flop signals may be provided to an XOR gate 206, and the EvenMidData_b4_latch and the OddMidData_af_flop may be provided to a NAND gate 208. Outputs of the XOR gate 206 and the NAND gate 208 may be provided to an AND gate 210, and an output of the AND gate 210 may be provided to a latch 212.

Additionally, the EvenData_af_latch signal and the OddData_b4_flop signals may be provided to an XOR gate 214, and the EvenMidData_af_latch and the OddMidData_b4_flop signals may be provided to a NAND gate 216. Outputs of the XOR gate 214 and the NAND gate 216 may be provided to an AND gate 218, and an output of the AND gate 218 may be provided to a flip flop 220. Outputs of the latch 212 and the flip flop 220 may be provided to a MUX 222 to generate the serialized EQ0 signal. At the serializer 204, the EvenMidData_b4_latch and OddMidData_af_flop signals may be provided to an XOR gate 224, and the EvenMidData_af_latch and OddMidData_b4_flop signals may be provided to an XOR gate 226. An output of the XOR gate 224 may be provided to a latch 228, and an output of the XOR gate 226 may be provided to the flip flop 230.

Outputs of the latch 228 and the flip flop 230 may act as select lines for respective MUXes 232 and 234. As illustrated, the MUX 232 may select between the output of the latch 212 or the flip flop 220 of the serializer 202 based on the output of the latch 228. Further, the MUX 234 may select the output of the flip flop 220 of the serializer 202 based on the output of the flip flop 230. Outputs of the MUX 232 and the MUX 234 may be provided to a MUX 236 to generate the serialized EQ1 signal.

The EQ0 and EQ1 signals may be provided to respective time clock outs (TCO) 238 and 240, which may be used to adjust rising and falling edges of the Eqseg0 and Eqseg1 signals. The TCO 238 may provide the EQ0 signal with an inverted slewdelay_bypass to slew delay control circuitry 242, which may create a delay difference between the Eqseg0 and Eqseg1 signal to control a slew rate of the Eqseg0 and Eqseg1 signals. For higher speeds, for example, the slewdelay_bypass may be asserted, which may lead to reduced slew delay of the Eqseg0 and Eqseg1 signals. Further, during one-level or two-level communication (e.g., not CPHY mode), the TCO 240 may be disabled. This may gate the EQ1 signal, saving power.

An output of the slew delay control circuitry 242, the slewdelay_bypass, the inverted slewdelay_bypass, the EQ0 signal, and the EQ1 signal may be provided to EQseg1 control circuitry 244 to generate the EQseg1 signal. As illustrated, the output of the slew delay control circuitry 242 and the inverted slewdelay_bypass may be provided to a NAND gate 246, and the EQ1 and slewdelay_bypass signals may be provided to a NAND gate 248. Outputs of the NAND gate 246 and the NAND gate 248 may be provided to a NAND gate 250, and the NAND gate 250 may generate the EQ1seg1 signal.

The EQ0 signal may be provided to EQseg1 control circuitry 244 to generate the EQseg0 signal. As illustrated, the EQ0 signal may be provided to a NAND gate 254 with a ground input. Ground inputs may also be provided to a NAND gate 256, and outputs of the NAND gates 254 and 256 may be provided to a NAND gate 258 to generate the EQseg0 signal. The EQseg0 control circuitry 252 may be structured as such (e.g., with grounded NAND inputs) to be substantially the same as the structure of the EQseg1 control circuitry. As such, delays of the EQseg0 signals and EQseg1 signals may be substantially the same.

As mentioned, the equalization circuitry 200 may generate nine different combinations of the Eqseg0 and Eqseg1 signals. The nine different combination may be generated by the equalization circuitry 200 based on a previous state and a current state, which may be indicated by the dataseg0 and dataseg1 signals. For example, the previous state and current state may be a H0, H1, or H2 high sub-level, H3 being a higher sub-level than H2, which is a higher sub-level than H1, an M1-, M0, or M1+ medium sub-level, M1+ being a higher sub-level than M1, which is a higher sub-level than M1-, or a low L0, L1, or L2 sub-level, L2 being a higher sub-level than L1, which is a higher sub-level than L0. Examples of Eqseg0 and Eqseg1 signals are shown in the table below:

**Table 2. Eqseg0 and Eqseg1 Signals**

| Output voltage level | | DATASEG0 | | DATASEG1 | | EQSEG0 | EQSEG1 |
|---|---|---|---|---|---|---|---|
| Previous state | Current state | Previous state | Current state | Previous state | Current state | | |
| H0/H1/H2 | H0 | 1 | 1 | 1 | 1 | 1 | 1 |
| H0/H1/H2 | M1- | 1 | 1 | 1 | 0 | 1 | 0 |
| H0/H1/H2 | L2 | 1 | 0 | 1 | 0 | 0 | 0 |
| M1-/M0/M1+ | H1 | 1 | 1 | 0 | 1 | 1 | 0 |
| M1-/M0/M1+ | M0 | 1 | 1 | 0 | 0 | 0 | 0 |
| M1-/M0/M1+ | L1 | 1 | 0 | 0 | 0 | 0 | 1 |
| L0/L1/L2 | H2 | 0 | 1 | 0 | 1 | 0 | 0 |
| L0/L1/L2 | M1+ | 0 | 1 | 0 | 0 | 0 | 1 |
| L0/L1/L2 | L0 | 0 | 0 | 0 | 0 | 1 | 1 |

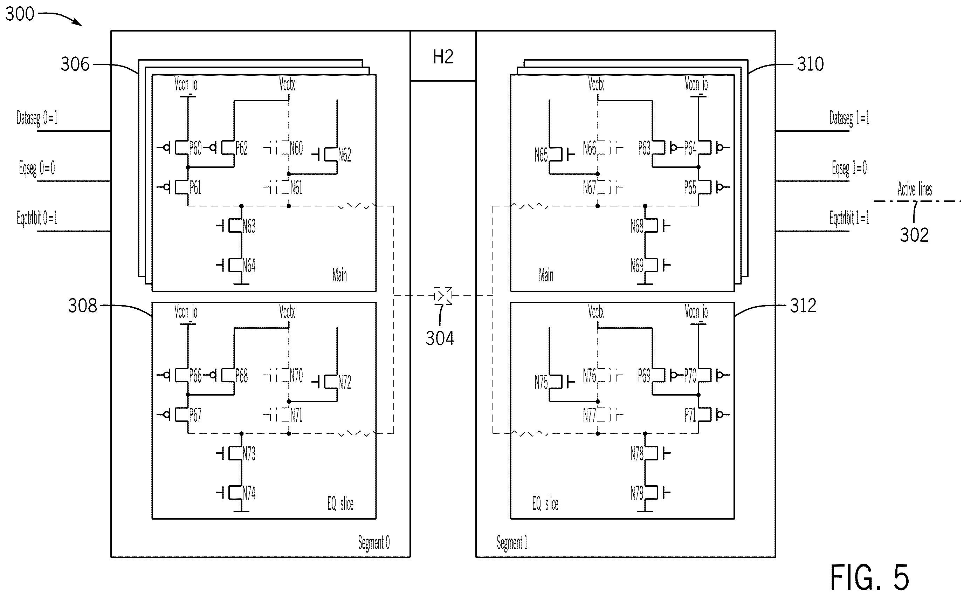

FIGS. 5-13 illustrate schematic diagrams of driver circuitry 300 operating in the nine different scenarios of a three-level communication scheme to generate the nine different equalization signals. The driver circuitry 300 includes a main Segment0 portion 306 that corresponds to the Dataseg0 signal, an EQ Segment0 portion 308 that corresponds to the EqSeg0 signal, a main Segment 1 portion 310 that corresponds to the Dataseg1 signal, and an EQ Segment 1 portion that corresponds to the Eqseg1 signal. FIG. 5 shows the driver circuitry 300 when Dataseg0 and Dataseg1 are asserted and Eqseg0 and Eqseg1 are not asserted (e.g., the H2 state). In FIG. 5, as shown by active lines 302, the transistors N60, N61, N66, N67, N70, N76, and N76 are turned on, connecting a pad 304 to the Vcctx voltage at each of the portions 306, 308, 310, and 312, while remaining transistors are turned off.

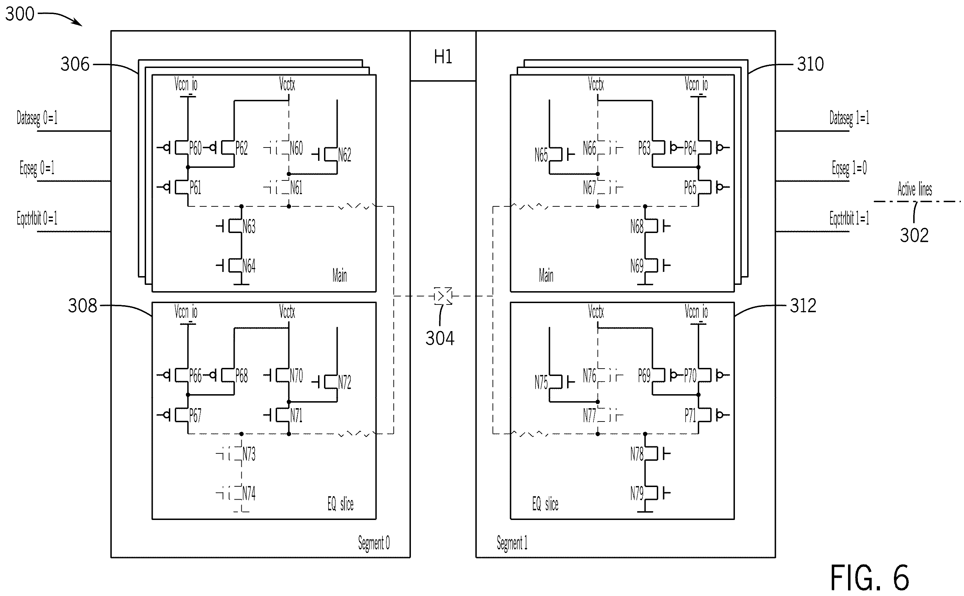

FIG. 6 shows the driver circuitry 300 when Dataseg0 and Dataseg1 are asserted, Eqseg0 is asserted, and Eqseg1 is not asserted (e.g., the H1 state). As illustrated, the N60, N61, N66, N67, N76, and N77 are turned on, connecting the pad 304 to the Vcctx at the portions 306, 310, and 312, the transistors N73 and N74 are turned on, connecting the pad to ground at the portion 308, while the remaining transistors are turned off.

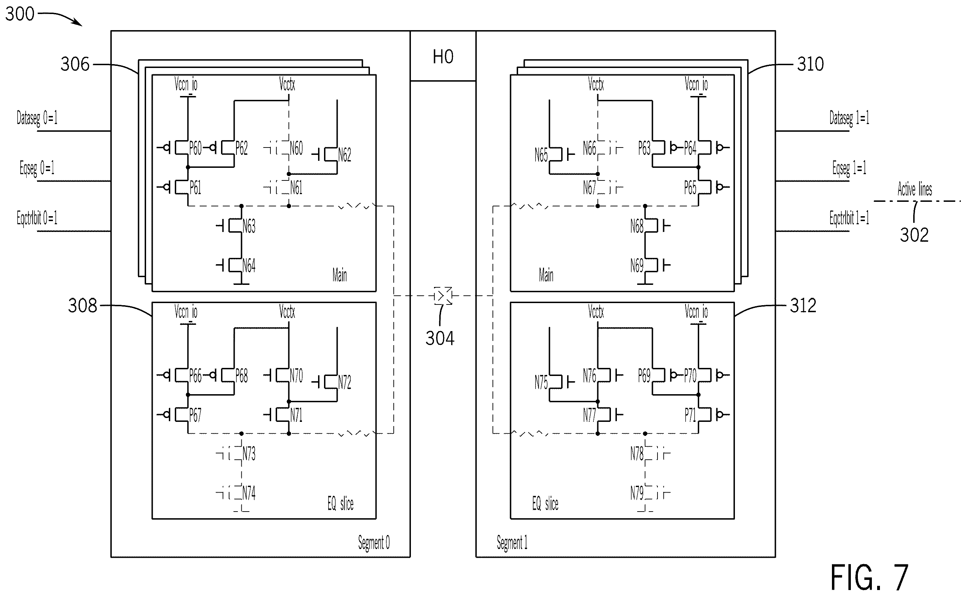

FIG. 7 shows the driver circuitry 300 when Dataseg0 and Dataseg1 are asserted and the Eqseg0 and Eqseg1 are asserted (e.g., the H0 state). As illustrated, the transistors N60, N61, N66, and N67 are turned on, connecting the pad 304 to the Vcctx at the portions 306 and 310, and the transistors N73, N74, N78, and N79 are turned on, connecting the pad to ground at the portion 308, while the remaining transistors are turned off.

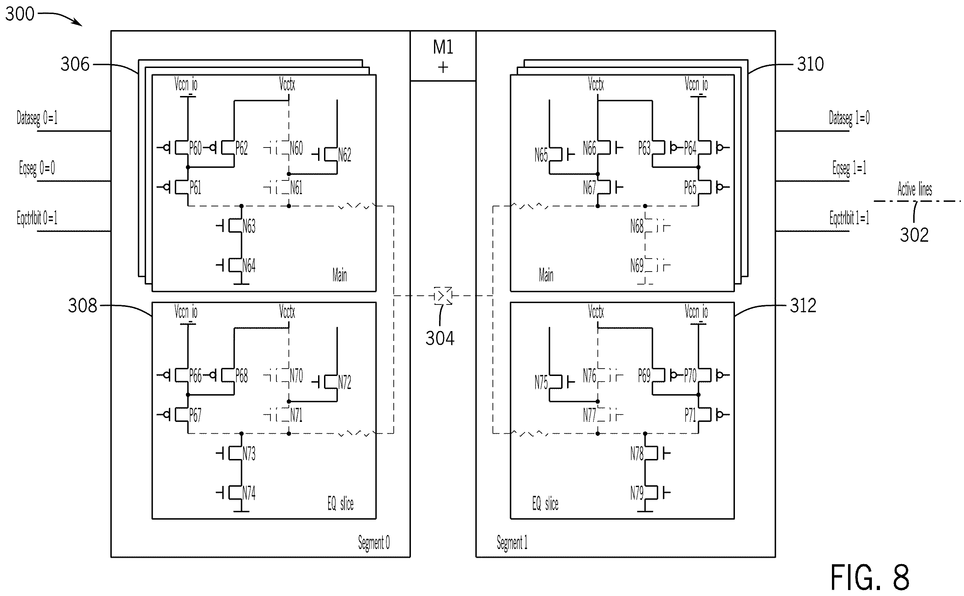

FIG. 8 shows the driver circuitry 300 when Dataseg0 signal is asserted, the Dataseg1 signal is not asserted, the Eqseg0 signal is not asserted, and the Eqseg1 signal is asserted (e.g., the M1+ state). As illustrated, the transistors N60, N61, N70, N71, N76, and N77 are turned on, connecting the pad 304 to the Vcctx at the portions 306, 308, and 312 and the transistors N68 and N69 are turned on, connecting the pad to ground at the portion 310, while the remaining transistors are turned off.

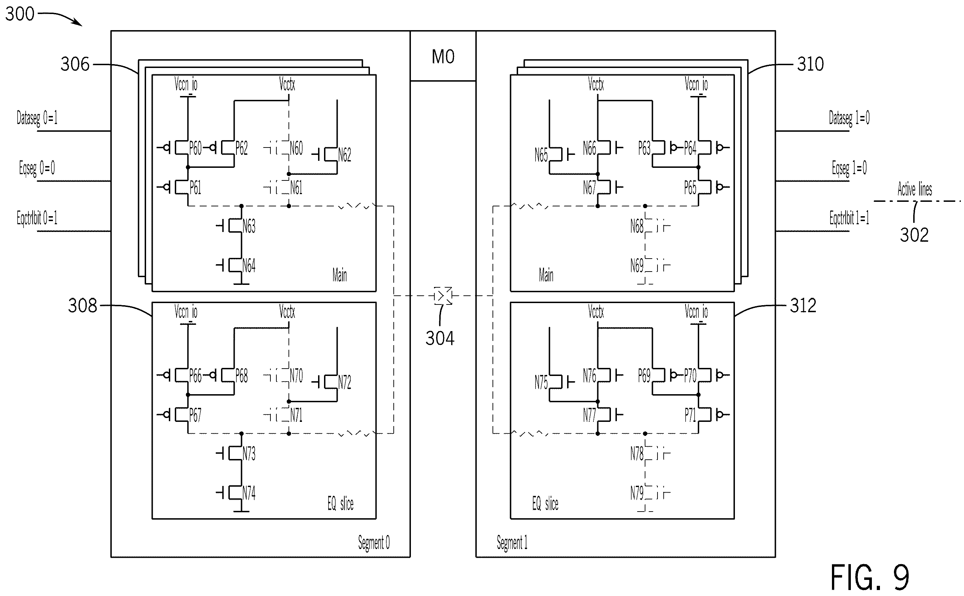

FIG. 9 shows the driver circuitry 300 when Dataseg0 signal is asserted, the Dataseg1 signal is not asserted, the Eqseg0 signal is not asserted, and the Eqseg1 signal is not asserted (e.g., the M0 state). As illustrated, the transistors N60, N61, N70, N71, and N76 are turned on, connecting the pad 304 to the Vcctx at the portions 306 and 308, and the transistors N68, N69, N78 and N79 are turned on, connecting the pad to ground at the portions 310 and 312, while the remaining transistors are turned off.

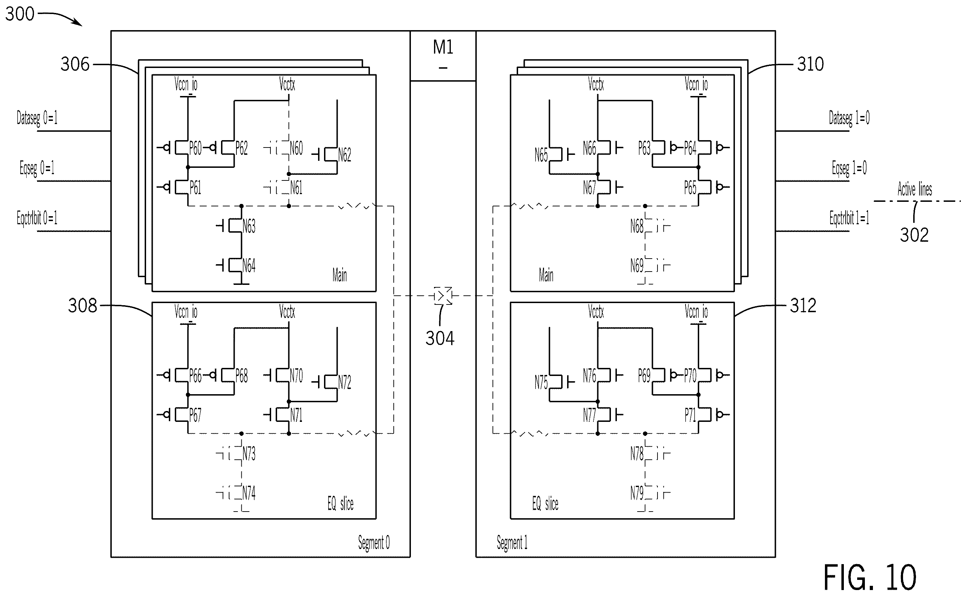

FIG. 10 shows the driver circuitry 300 when Dataseg0 signal is asserted, the Dataseg1 signal is not asserted, the Eqseg0 signal is asserted, and the Eqseg1 signal is not asserted (e.g., the M1- state). As illustrated, the transistors N60 and N61 are turned on, connecting the pad 304 to the Vcctx at the portion 306, and the transistors N68, N69, N73, N74, N78, and N79 are turned on, connecting the pad to ground at the portions 308, 310, and 312 while the remaining transistors are turned off.

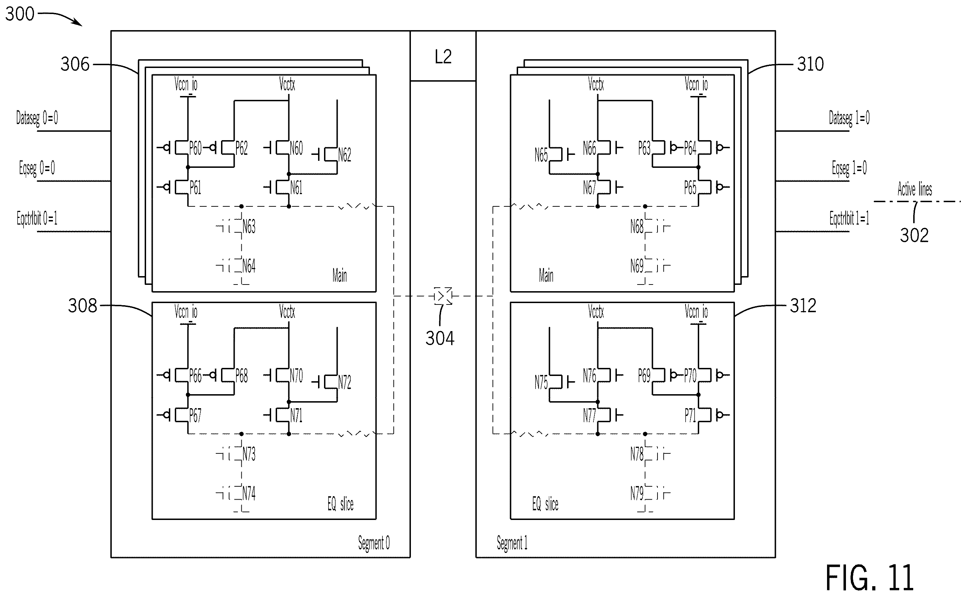

FIG. 11 shows the driver circuitry 300 when Dataseg0 signal is not asserted, the Dataseg1 signal is not asserted, the Eqseg0 signal is not asserted, and the Eqseg1 signal is not asserted (e.g., the L2 state). As illustrated, the transistors N63, N64, N68, N69, N73, N74, N78, and N79 are turned on, connecting the pad to ground at the portions 308, 310, and 312 while the remaining transistors are turned off.

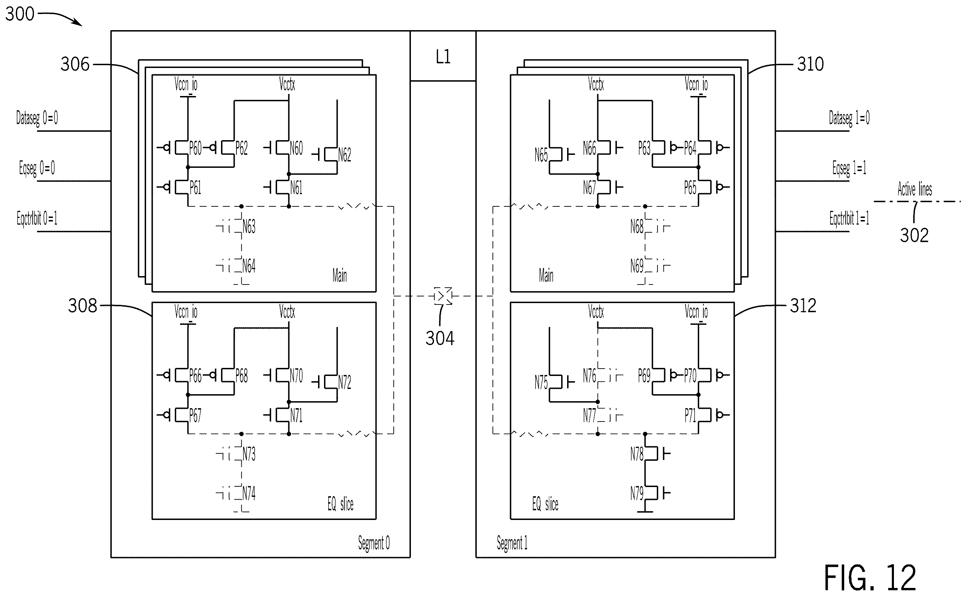

FIG. 12 shows the driver circuitry 300 when Dataseg0 signal is not asserted, the Dataseg1 signal is not asserted, the Eqseg0 signal is not asserted, and the Eqseg1 signal is asserted (e.g., the L1 state). As illustrated, the transistors N76 and N77 are turned on, connecting the pad 304 to the Vcctx at the portion 312, and the transistors N63, N64, N68, N69, N73, and N74 are turned on, connecting the pad to ground at the portions 306, 308, and 310, while the remaining transistors are turned off.

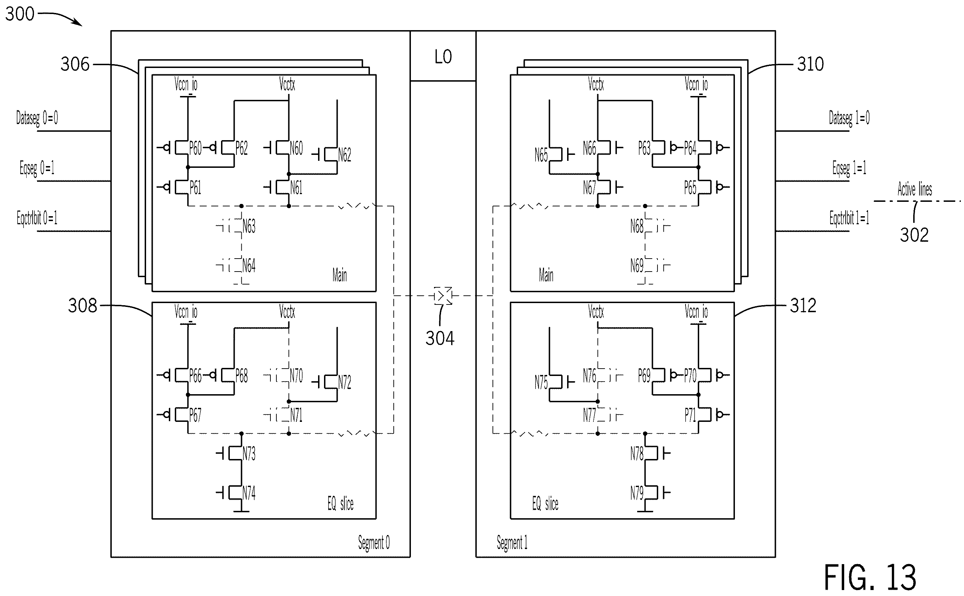

FIG. 13 shows the driver circuitry 300 when Dataseg0 signal is not asserted, the Dataseg1 signal is not asserted, the Eqseg0 signal is asserted, and the Eqseg1 signal is asserted (e.g., the L0 state). As illustrated, the transistors N70, N71, N76, and N77 are turned on, connecting the pad 304 to the Vcctx at the portions 308 and 312, and the transistors N63, N64, N68, and N69 are turned on, connecting the pad to ground at the portions 306 and 310, while the remaining transistors are turned off.

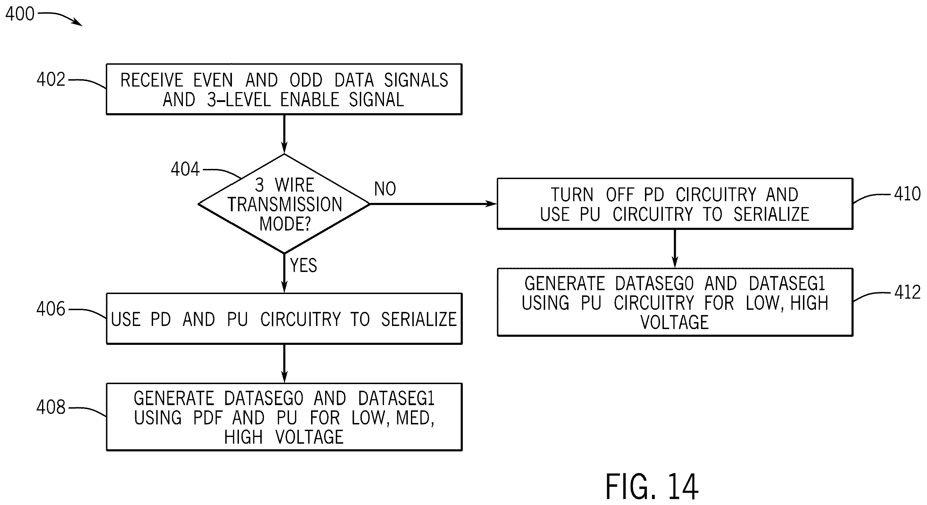

FIG. 14 is a flow chart of a method 400 for selectively generating voltage levels based on one-level, two-level, or three-level (e.g., one-voltage-level, two-voltage-level, three-voltage-level) communication schemes that may be performed by the transmit circuitry 30. In block 402, the transmit circuitry 30 may receive even and odd data signals and a three-level enable signal (e.g., the cphy_enable signal) from the I/O control circuitry. The even and odd data signals include even and odd portions of pull-up signals and pull-down signals. The pull-up signals may include PU_Even_Ph0 and PU_Even_Ph1 signals, which may be parallel versions of an even portion of the pull-up signal, and PU_Odd_Ph0 and PU_Odd_Ph1 signals, which may be parallel versions of an odd portion of the pull-up signal. The pull-down signals include PD_Even_Ph0 PD_Even_Ph1, PD_Odd_Ph0, and PD_Odd_Ph1 signals, which may include parallel versions of even and odd portions of the pull-down signal.

In block 404, the transmit circuitry 30 may determine a three-level (e.g., three-wire) communication scheme based on the three-level enable signal received from the I/O control circuitry 32. If the three-level enable signal is asserted, in block 406, the transmit circuitry may not gate (e.g., enable) ) pull-up circuitry that generates the EvenMidData and OddMidData signals. As such, the transmit circuitry 30 may generate, in block 408, three voltage levels at the dataseg0. If, however, the three-level enable signal is not asserted, in block 410, the transmit circuitry 30 may disable the three-level communication scheme by gating the pull-down circuitry. As such, the transmit circuitry 30 may generate, in block 412, fewer than three voltage levels at the dataseg0 and dataseg1 outputs. Further, the transmit circuitry may serialize the data signals into an EvenData signal and an OddData signals when the three-level communication scheme is disabled (in block 410) and may serialize the data signals into the EvenData signal, the OddData signal, an EvenMidData signal, and an OddData signal when the three-level communication scheme is enabled (in block 408).

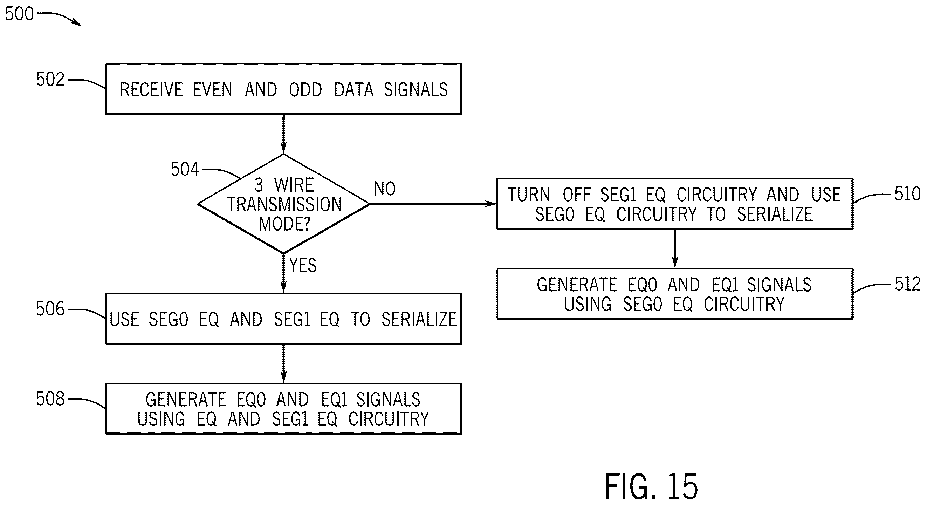

FIG. 15 is a flow chart of a method 500 for selectively generating equalization voltages based on one-level, two-level, or three-level communication schemes that may be performed by the equalization circuitry 200. In block 502, the equalization circuitry 200 may receive even and odd data signals from the transmit circuitry 30 at the serializers 202 and 204. The even and odd data signals may include the EvenData_b4_latch, OddData_af_flop EvenData_af_latch, and OddData_b4_flop signals received from the transmit circuitry 30. The even and odd data signals may also include signals that indicate a three-level communication scheme, including the EvenMidData_b4_latch and the OddMidData_af_flop signals, the EvenMidData_af_latch and the OddMidData_b4_flop signals, the EvenMidData_b4_latch and OddMidData_af_flop signals, and the EvenMidData_af_latch and OddMidData_b4_flop signals.

In block 504, the equalization circuitry 200 may determine a three-level communication scheme based on the signals that indicate the three-level communication scheme. If the signals indicate the three-level communication scheme, in block 506, the equalization circuitry 200 may use seg0 EQ circuitry (e.g., the serializer 202, the TCO 238) and the seg1 EQ circuitry (e.g., the serializer 204, the TCO 240 to serialize the EQ0 and EQ1 signals. As such, in block 508, the equalization circuitry 200 may selectively generate the EQ0 and EQ1 signals as nine different voltage level combinations (as shown in Table 2). If, however, the three-level communication scheme is not indicated, the equalization circuitry 200 may gate the seg1 circuitry in block 510, using only the seg0 circuitry. The equalization circuitry 200 may gate the TCO 240, for example. As such, in block 512, the equalization circuitry 200 may generate the EQ0 and EQ1 signals using only the seg0 EQ circuitry, and the EQ0 and EQ1 signals may thus have fewer than nine voltage level combinations (e.g., one combination, two combinations).

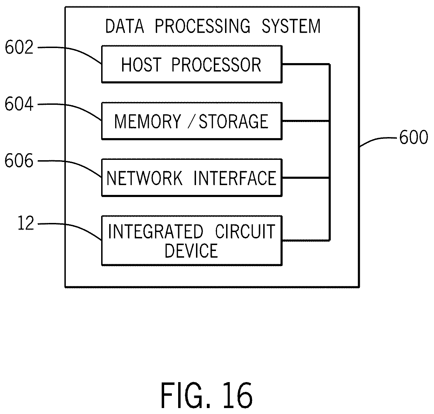

The transmit circuitry 30 and/or the equalization circuitry 200 may be used in a data processing system, such as a data processing system 600, shown in FIG. 16. This may allow a high-speed transceiver of the data processing system 600 to improve Multi-Protocol Input/Output (I/O) Communication. The data processing system 600 may include the transceiver 22, a host processor 602, memory and/or storage circuitry 604, and a network interface 606. The data processing system 600 may include more or fewer components (e.g., electronic display, user interface structures, application specific integrated circuits (ASICs)). Moreover, any of the circuit components depicted in FIG. 14 may include the transceiver 22. The host processor 602 may include any of the foregoing processors that may manage a data processing request for the data processing system 600 (e.g., to perform encryption, decryption, machine learning, video processing, voice recognition, image recognition, data compression, database search ranking, bioinformatics, network security pattern identification, spatial navigation, cryptocurrency operations, or the like). The memory and/or storage circuitry 604 may include random access memory (RAM), read-only memory (ROM), one or more hard drives, flash memory, or the like. The memory and/or storage circuitry 604 may hold data to be processed by the data processing system 600. In some cases, the memory and/or storage circuitry 604 may also store configuration programs (e.g., bitstreams, mapping function) for programming the transceiver 22. The network interface 606 may allow the data processing system 600 to communicate with other electronic devices. The data processing system 600 may include several different packages or may be contained within a single package on a single package substrate. For example, components of the data processing system 600 may be located on several different packages at one location (e.g., a data center) or multiple locations. For instance, components of the data processing system 600 may be located in separate geographic locations or areas, such as cities, states, or countries.

The data processing system 600 may be part of a data center that processes a variety of different requests. For instance, the data processing system 600 may receive a data processing request via the network interface 606 to perform encryption, decryption, machine learning, video processing, voice recognition, image recognition, data compression, database search ranking, bioinformatics, network security pattern identification, spatial navigation, digital signal processing, or other specialized tasks.

The techniques and methods described herein may be applied with other types of integrated circuit systems. For example, the multi-level signaling system of this disclosure may be used with central processing units (CPUs), graphics cards, hard drives, or other components.

While the embodiments set forth in the present disclosure may be susceptible to various modifications and alternative forms, specific embodiments have been shown by way of example in the drawings and have been described in detail herein. However, it should be understood that the disclosure is not intended to be limited to the particular forms disclosed. The disclosure is to cover all modifications, equivalents, and alternatives falling within the spirit and scope of the disclosure as defined by the following appended claims.

### EXAMPLE EMBODIMENTS

EXAMPLE EMBODIMENT 1. A system comprising: transmit circuitry configured to: receive one or more input signals and an enable signal, the enable signal indicating whether a three-level communication scheme is enabled; generate one or more data signals based on the one or more input signals and the enable signal; and equalization circuitry configured to: receive the one or more data signals; and configured to: selectively generate a first set of equalization voltages based on the one or more data signals indicating the three-level communication scheme; or selectively generate a second set of equalization voltages based on the one or more data signals not indicating the three-level communication scheme.

EXAMPLE EMBODIMENT 2. The system of example embodiment 1, wherein the transmit circuitry is configured to, based on the one or more data signals: selectively generate a first set of output voltages in response to the enable signal indicating that the three-level communication scheme is enabled; or selectively generate a second set of output voltages in response to the enable signal indicating that the three- level communication scheme is not enabled.

EXAMPLE EMBODIMENT 3. The system of example embodiment 2, wherein the transmit circuitry comprises one or more serializers configured to serialize the one or more data signals into the first set of output voltages or the second set of output voltages.

EXAMPLE EMBODIMENT 4. The system of example embodiment 2, wherein the transmit circuitry comprises gating circuitry configured to: enable a first serializer and a second serializer of the one or more serializers in response to the three-level communications scheme being enabled, or gate a first serializer of the one or more serializers in response to the three-level communications scheme not being enabled.

EXAMPLE EMBODIMENT 5. The system of example embodiment 4, wherein each of the one or more serializers comprises a multiplexer (MUX), a latch, and a flip flop.

EXAMPLE EMBODIMENT 6. The system of example embodiment 2, comprising slew-delay control circuitry configured to cause a delay in generating the first set of output voltages or the second set of output voltages.

EXAMPLE EMBODIMENT 7. The system of example embodiment 1, wherein the transmit circuitry is configured to selectively generate the first set of output voltages or selectively generate the second set of output voltages as part of a field-programmable gate array (FPGA) configuration.

EXAMPLE EMBODIMENT 8. The system of example embodiment 7, wherein the transmit circuitry comprises one or more multiplexers, the one or more multiplexers configured to serialize the one or more input signals to generate the one or more data signals.

EXAMPLE EMBODIMENT 9. The system of example embodiment 1, wherein the one or more data signals includes: a first even data signal and a first odd data signal if the enable signal indicates that the three-level communication scheme is enabled, or the first even data signal, the first odd data signal, a second even signal, and a second odd signal if the enable signal indicates that the three-level communication scheme is not enabled.

EXAMPLE EMBODIMENT 10. The system of example embodiment 1, wherein the three-level communication scheme not being enabled corresponds to a two-voltage-level communication scheme being enabled.

EXAMPLE EMBODIMENT 11. The system of example embodiment 1, wherein the three-level communication scheme comprises a camera physical layer (CPHY) communication scheme.

EXAMPLE EMBODIMENT 12. A method, comprising: receiving, at input/output (I/O) circuitry of an integrated circuit (IC), one or more input signals and an enable signal, the enable signal indicating a communication scheme; selectively generating, at the input/output (I/O) circuitry of the integrated circuit (IC), in response to the enable signal indicating a three-voltage-level communication scheme, a three-level voltage using first circuitry and second circuitry; and selectively generating, at the input/output (I/O) circuitry of the integrated circuit (IC), in response to the enable signal not indicating the three-voltage-level communication scheme, a one-level voltage or a two-level voltage using the first circuitry. EXAMPLE EMBODIMENT EXAMPLE EMBOIDMENT 13.The method of example embodiment 12, wherein the one-level voltage, the two-level voltage, or the three-level voltage are generated as a first signal at a first output and a second signal at a second output.

EXAMPLE EMBODIMENT 14. The method of example embodiment 12, comprising: selectively generating, in response to the enable signal indicating the three-voltage-level communication scheme, a first set of equalization signals, or selectively generating, in response to the enable signal not indicating the three-voltage-level communication scheme, a second set of equalization signals.

EXAMPLE EMBODIMENT 15. The method of example embodiment 14, wherein the first set of equalization signals comprises more than five equalization signals and the second set of equalization signals comprises fewer than five equalization signals.

EXAMPLE EMBODIMENT 16. A system, comprising: serializer circuitry configured to generate an output control voltage at two outputs based on one or more input data signals and one of a plurality of communication schemes, the communication schemes defining a number of voltage levels at which one or more integrated circuit (IC) devices communicate; equalization circuitry configured to generate an equalization control voltage at two equalization outputs based on the one or more input data signals and the one of a plurality of communication schemes; first driver circuitry configured to drive a first pad voltage to an output voltage based on the output control voltage; and second driver circuitry configured to drive a second pad voltage to an equalization voltage based on the equalization control voltage.

EXAMPLE EMBODIMENT 17. The system of example embodiment 16, wherein, to drive the second pad voltage to the equalization voltage, the second driver circuitry is configured to selectively enable a plurality of n-channel metal oxide semiconductor (NMOS) transistors based on the output control voltage and the equalization control voltage.

EXAMPLE EMBODIMENT 18. The system of example embodiment 16, wherein, to drive the first pad voltage to the output voltage, the first driver circuitry is configured to selectively enable one or more n-channel metal oxide semiconductor (NMOS) transistors based on the equalization control voltage.

EXAMPLE EMBODIMENT 19. The system of example embodiment 16, wherein the serializer circuitry is configured to serialize the one or more input data signals, and wherein the equalization circuitry is configured to generate the equalization control voltage based on the serialized one or more input data signals.

EXAMPLE EMBODIMENT 20. The system of example embodiment 19, wherein the serializer circuitry is configured to: generate a first set of serialized input data signals when the one of the plurality of communication schemes comprises a multi-level communication scheme; and generate a second set of serialized input data signals when the one of the plurality of communication schemes comprises a one-level communication scheme or a two-level communication scheme, wherein the second set comprises fewer serialized input data signals than the first.

## Claims

1. A system comprising:
transmit circuitry configured to:
receive one or more input signals and an enable signal, the enable signal indicating whether a three-level communication scheme is enabled;
generate one or more data signals based on the one or more input signals and the enable signal; and
equalization circuitry configured to:
receive the one or more data signals; and configured to:
selectively generate a first set of equalization voltages based on the one or more data signals indicating the three-level communication scheme; or
selectively generate a second set of equalization voltages based on the one or more data signals not indicating the three-level communication scheme.

2. The system of claim 1, wherein the transmit circuitry is configured to, based on the one or more data signals:
selectively generate a first set of output voltages in response to the enable signal indicating that the three-level communication scheme is enabled; or
selectively generate a second set of output voltages in response to the enable signal indicating that the three-level communication scheme is not enabled.

3. The system of claim 2, wherein the transmit circuitry comprises one or more serializers configured to serialize the one or more data signals into the first set of output voltages or the second set of output voltages.

4. The system of claim 2 or 3, wherein the transmit circuitry comprises gating circuitry configured to:
enable a first serializer and a second serializer of the one or more serializers in response to the three-level communications scheme being enabled, or
gate a first serializer of the one or more serializers in response to the three-level communications scheme not being enabled.

5. The system of claim 4, wherein each of the one or more serializers comprises a multiplexer (MUX), a latch, and a flip flop.

6. The system of one of the claims 2-5, comprising slew-delay control circuitry configured to cause a delay in generating the first set of output voltages or the second set of output voltages.

7. The system of one of the claims 2-6, wherein the transmit circuitry is configured to selectively generate the first set of output voltages or selectively generate the second set of output voltages as part of a field-programmable gate array (FPGA) configuration.

8. The system of one of the previous claims, wherein the transmit circuitry comprises one or more multiplexers, the one or more multiplexers configured to serialize the one or more input signals to generate the one or more data signals.

9. The system of one of the previous claims, wherein the one or more data signals includes:
a first even data signal and a first odd data signal if the enable signal indicates that the three-level communication scheme is enabled, or
the first even data signal, the first odd data signal, a second even signal, and a second odd signal if the enable signal indicates that the three-level communication scheme is not enabled.

10. The system of one of the previous claims, wherein the three-level communication scheme not being enabled corresponds to a two-voltage-level communication scheme being enabled.

11. The system of one of the previous claims, wherein the three-level communication scheme comprises a camera physical layer (CPHY) communication scheme.

12. A method, comprising:
receiving, at input/output (I/O) circuitry of an integrated circuit (IC), one or more input signals and an enable signal, the enable signal indicating a communication scheme;
selectively generating, at the input/output (I/O) circuitry of the integrated circuit (IC), in response to the enable signal indicating a three-voltage-level communication scheme, a three-level voltage using first circuitry and second circuitry; and
selectively generating, at the input/output (I/O) circuitry of the integrated circuit (IC), in response to the enable signal not indicating the three-voltage-level communication scheme, a one-level voltage or a two-level voltage using the first circuitry.

13. The method of claim 12, wherein the one-level voltage, the two-level voltage, or the three-level voltage are generated as a first signal at a first output and a second signal at a second output.

14. The method of claim 12 or 13, comprising:
selectively generating, in response to the enable signal indicating the three-voltage-level communication scheme, a first set of equalization signals, or
selectively generating, in response to the enable signal not indicating the three-voltage-level communication scheme, a second set of equalization signals.

15. The method of claim 14, wherein the first set of equalization signals comprises more than five equalization signals and the second set of equalization signals comprises fewer than five equalization signals.
